Europäisches Patentamt

European Patent Office

Office européen des brevets

(11) Veröffentlichungsnummer: **0 490 229 A2**

## EUROPÄISCHE PATENTANMELDUNG

(21) Anmeldenummer: **91120735.5**

(22) Anmeldetag: **03.12.91**

(51) Int. Cl.5: **H01L 21/285**, H01L 21/3205

(30) Priorität: **12.12.90 DE 4039699**

(43) Veröffentlichungstag der Anmeldung:
**17.06.92 Patentblatt 92/25**

(84) Benannte Vertragsstaaten:
**DE FR GB NL**

(71) Anmelder: **BASF Aktiengesellschaft**
**Carl-Bosch-Strasse 38**
**W-6700 Ludwigshafen(DE)**

(72) Erfinder: **Petermann, Juergen, Prof. Dr.**
**Westpreussenweg 12**
**W-2150 Buxtehude(DE)**
Erfinder: **Jandt, Klaus**
**Suhrsweg 16**
**W-2000 Hamburg 60(DE)**
Erfinder: **Hoffmann, Thomas**
**Mansteinstrasse 7**
**W-2000 Hamburg 20(DE)**

(54) Verfahren zur Herstellung selektiv bedampfter Strukturen.

(57) Die Erfindung betrifft ein Verfahren zum selektiven Aufbringen von Metallen, Halbmetallen oder Halbleitermaterialien auf mikrostrukturierte Substrate, wobei die Strukturierung der Substrate durch Veränderung der Oberfläche in physikalischer oder chemischer Hinsicht erfolgt und aufgrund des unterschiedlichen Adsorptionsverhaltens der aufzubringenden Metalle, Halbmetalle oder Halbleitermaterialien unterschiedliche Abscheidungsraten zu einer durch die vorgegebene Struktur bedingten selektiven Beschichtung führt.

EP 0 490 229 A2

Die Erfindung betrifft ein Verfahren zum selektiven Aufbringen von Metallen, Halbmetallen oder Halbleitermaterialien auf mikrostrukurierte Substrate, wobei die Strukturierung der Substrate durch Veränderung der Oberfläche in physikalischer oder chemischer Hinsicht erfolgt und aufgrund des unterschiedlichen Adsorptionsverhaltens der aufzubringenden Metalle, Halbmetalle oder Halbleitermaterialien unterschiedliche Abscheidungsraten zu einer durch die vorgegebene Struktur bedingten selektiven Beschichtung führt.

Die Technologie zur Herstellung von Anordnungen mit submikroskopischen Strukturen erfordert für die Bildung mikrolithographischer Muster insbesondere bei der Herstellung von Halbleitern, integrierten Schaltkreisen, Mikroschaltungen und dergleichen Elektronenstrahl-empfindliche Schichten mit der Möglichkeit einer extrem genauen Kontrolle der Dimensionsstabilität. Hierfür werden im allgemeinen sogenannte Elektronenstrahlresists eingesetzt. Gegenüber den bekannten Photoresists weisen die Elektronenstrahlresist den Vorteil auf, daß mit ihnen eine erheblich bessere Auflösung erzielt werden kann. Das Auftragen der Resistmaterialien auf das weiterzuverarbeitende Substrat erfolgt dabei aus Lösung. Ebenso wird die Entwicklung des Resistmusters nach der bildmäßigen Bestrahlung des Resistmaterials im allgemeinen mit einem Entwicklerlösungsmittel durchgeführt. Der Einsatz von Lösungsmittel sowie dessen Wiederaufarbeitung stellen einen nicht unbeachtlichen Aufwand dar. Es wurde auch schon vorgeschlagen, die Flüssig-Entwicklung der Resistschichten durch eine Trocken-Entwicklung zu ersetzen, indem die bildmäßig belichtete Resistschicht mit einem Plasmagas geätzt wird (DE-C 27 26 813 und EP-A 17 032). Für die Trockenentwicklung von Resistschichten mittels Plasma-Ätzung sind jedoch technisch aufwendige Apparaturen notwendig. Aus der DE-A 1 152 534 ist ein Verfahren zum Vernetzen von Kohlenwasserstoffen bekannt, die mit ultraviolettem Licht mit Wellenlängen zwischen 200 und 300 m$\mu$ bestrahlt werden, wobei die Entfernung der nicht-bestrahlten Teile durch Auswaschen mit Toluol, Xylol oder Hexan erfolgt. Ein Hinweis auf die Vernetzung von Polyethylen oder Paraffinwachs durch Bestrahlung mit ultraviolettem Licht ist auch der Publikatation von J. Kosar "Light sensitive systems" in J.P.C. 1965, Seiten 137-157, Wiley, New York, zu entnehmen. Aus der EP-A 167 111 ist ein Verfahren bekannt, bei dem Paraffin-Resistmaterial durch Aufdampfen in dünner Schicht auf ein Substrat aufgebracht, in einem vorbestimmten Muster unter Vernetzung bestrahlt wird und anschließend die nichtbestrahlten Bereiche der Resistschicht durch Abdampfen des unvernetzten Paraffins entfernt werden.

Der vorliegenden Erfindung liegt die Aufgabe zugrunde, ein Verfahren zum selektiven Aufbringen von Metallen, Halbmetallen oder Halbleitermaterialien auf mikrostrukturierte Substrate aufzuzeigen, welches in einfacher Weise durchgeführt und mit dem gleichzeitig eine hohe Auflösung eingeschriebener Strukturen erzielt werden kann. Insbesondere war es Aufgabe der Erfindung Metall-, Halbmetall- oder Halbleiterschicht-Mikrostrukturenmit sehr scharfen Bereichsgrenzen ohne Masken und Entwicklung herzustellen.

Diese Aufgabe wird durch das erfindungsgemäße Verfahren gelöst.

Gegenstand der Erfindung ist demzufolge ein Verfahren zum selektiven Aufbringen von Metallen, Halbmetallen oder Halbleitermaterialien auf mikrostrukturierte Substrate, wobei die Mikrostrukturierung durch Veränderung der Oberflächentopographie oder Molekularstruktur der Substrate mittels elektromagnetischer Strahlen erzeugt wird und anschließend auf den so veränderten Substraten das Aufbringen der Metalle, Halbmetalle oder Halbleitermaterialien durch selektive Kondensation erfolgt.

Gegenstand der Erfindung sind des weiteren spezielle Ausgestaltungsformen dieses Verfahrens gemäß der nachfolgenden Beschreibung der Erfindung.

Bei dem erfindungsgemäßen Verfahren werden zuerst die Veränderungen der Substratoberfläche durch elektromagnetische Strahlen, vorzugsweise Elektronenstrahlen, zur Strukturierung, d.h. zur Erzeugung unterschiedlicher Physisorbtions- oder Chemisorptionseigenschaften, herangezogen. Die vorzugsweise eingesetzten Elektronenstrahlen gestatten eine hohe Auflösung und außerdem durch eine entsprechende Steuerung des Strahls ein Einschreiben von vorbestimmten Strukturen, bzw. Informationen in das Substrat. Hierfür verwenden lassen sich Substrate, die zumindest auf der Oberfläche organische Moleküle oder Polymere aufweisen, welche sich durch die Wechselwirkung mit elektromagnetischen Strahlen, insbesondere Elektronenstrahlen lokal verändern lassen. Im Rahmen des erfindungsgemäßen Verfahrens lassen sich u.a. teilkristallisierte Kunststoffe, Polyethylene, Polymethylmethacrylate, Paraffine, kurzkettige Oligomere oder Langmuir-Blodgett-Filme einsetzen.

Beispielhaft sei das erfindungsgemäße Verfahren anhand von Paraffinschichten erläutert. Hierzu werden Paraffinfilme auf amorphe Kohlenstoffsubstrate aufgebracht. Dies geschieht entweder durch Aufdampfen des Paraffins im Vakuum oder durch Abscheiden eines Paraffinfilms aus einer Lösung auf heißer Phosphorsäure, Floaten in Wasser und Übertragen auf das Kohlenstoffsubstrat.

Bei den einzusetzenden Paraffinen handelt es sich um geradkettige oder verzweigte, gesättigte, aliphatische Kohlenwasserstoffe, die gegebenenfalls auch, beispielsweise durch Carboxylgruppen, Estergruppen, Hydroxylgruppen oder dergleichen, substituiert sein können. Vorzugsweise werden jedoch unsubstituierte Paraffin-Kohlenwasserstoffe eingesetzt. Die erfindungsgemäß einzusetzenden Paraffine sind im allgemeinen bei Raumtemperatur fest und haben vorzugsweise einen Schmelzpunkt im Bereich von 30 bis 150° C, insbesondere im Bereich von etwa 40 bis 120° C. Es können aber auch niedrigschmelzendere, bei Raumtemperatur üblicherweise flüssige Paraffine eingesetzt werden, beispielsweise solche mit einem Fließpunkt bis hinab zu etwa -30° C, insbesondere wenn unter Kühlung des Substrates bei Temperaturen unterhalb des Fließpunkts der Paraffine gearbeitet wird. Die bevorzugt eingesetzten Paraffine lassen sich bei erhöhter Temperatur, gegebenenfalls unter Anlegen eines Vakuums, ohne nennenswerte Zersetzung und insbesondere ohne Rückstandsbildung verdampfen. Besonders vorteilhaft sind Paraffine mit mindestens 10 C-Atomen und insbesondere solche, die etwa 20 bis 70 C-Atome besitzen. Das Molekulargewicht dieser Paraffine liegt im Bereich von 130 bis 1000. Die Paraffine können einzeln oder in Mischung miteinander eingesetzt werden. Bei Paraffinen mit höherer C-Atom-Zahl handelt es sich in aller Regel um Gemische von Paraffinen etwa gleicher Kettenlänge und gleichen Molekulargewichts. In dem erfindungsgemäßen Verfahren können aber auch Mischungen von Paraffinen unterschiedlicher Kettenlänge und unterschiedlichen Molekulargewichts eingesetzt werden.

Der auf dem Substrat befindliche Paraffinfilm wird mit einer elektromagnetischen Strahlung, die eine Vernetzung des Paraffins in den bestrahlten Bereichen zu bewirken vermag, bestrahlt. Hierfür kommen insbesondere energiereiche Strahlen, wie z.B. Elektronenstrahlen zur Anwendung. So können in dem erfindungsgemäßen Verfahren beispielsweise Elektronenstrahlen mit einer Beschleunigungsspannung von etwa 10 bis 40 KeV, aber auch solche mit einer Beschleunigungsspannung von 100 bis 300 oder mehr KeV verwendet werden. Die Strahlendosis liegt üblicherweise im Bereich von $10^{-5}$ bis $10^{-10}$ C/cm$^2$. Typischer Weise wird mit einer Bestrahlungsdauer beispielsweise im Bereich von 0,1 bis 10 Minuten, vorzugsweise im Bereich von 0,5 bis 2 Minuten, gearbeitet. Bei dieser Bestrahlung im Rastermodus verursachen die Elektronen freie Radikale in den Paraffinmolekülen, die dann zu einem Polyethylenmakromolekül vernetzen, das einen niedrigeren Dampfdruck aufweist als das ursprünglich eingesetzte Material.

Das nicht vernetzte Paraffin wird anschließend im Vakuum abgedampft, wobei sich je nach eingesetztem Paraffin Drücke von $10^{-1}$ bis $10^{-5}$ mbar bei Temperaturen zwischen -50 und 200° C als vorteilhaft erwiesen haben. Die danach zurückbleibenden Strukturen an vernetztem Paraffin lassen sich je nach Strahlendosis zwischen 50 bis 1000 nm breitgestalten.

Auf diese mikrostrukturierten Flächen lassen sich nun die Metalle, Halbmetalle oder Halbleitermaterialien selektiv durch Kondensation aufbringen. Das Verhältnis von Adsorptionsrate zur Desorptionsrate der aufgebrachten Materialien ist abhängig von der Veränderung der Oberfläche und beeinflußt die Keimbildung und damit die dauerhafte Abscheidung des aufgedampften Materials, wodurch sich die selektive Abscheidung bewirken läßt. Geeignete Materialien sind hierfür u.a. Tellur, Silber, Wismut, Aluminium, Kupfer, Cadmium, Antimon, Selen oder Wolframselenid die durch Widerstandsheizung im Hochvakuum auf das wie beschrieben strukturierte Substrat aufgedampft werden. Dies geschieht durch Kondensation des übersättigten Metalldampfes auf dem Substrat. Die Übersättigung wird durch die Temperatur des Substrates und die Aufdampfrate eingestellt.

Die Kondensation aus der Gas- bzw. Dampfphase ist solange die feste oder flüssige Phase noch nicht vorhanden ist durch die Entstehung mikroskopischer Keime der festen oder flüssigen Phase gekennzeichnet. Diese Keime bestehen zunächst aus wenigen Atomen oder Molekülen, die durch zufällige Zusammenstöße (Fluktuationen) entstanden sind. Sie können durch Fluktuationen zerfallen oder weiterwachsen. Für den Kondensationsvorgang ist die Entstehung kritischer Keime besonders wesentlich. Subkritische Keime sind instabil in dem Sinne, daß die Wahrscheinlichkeit ihres Zerfalls größer ist als die Wahrscheinlichkeit für die Anlagerung weiterer Atome an den Keim. Bei subkritischen Keimen befinden sich verhältnismäßig viele Partikel an der Oberfläche und damit in einer schwächer gebundenen Lage als Partikel im Innern des Keimes. Die Schaffung dieser Phasengrenzflache zum umgebenden Gas erfordert Arbeit und führt für kleine Keime zu einem Anstieg ihrer freien Energie. Erst ab einer bestimmten Größe überwiegt der Energiegewinn durch das Volumen der entstehenden festen bzw. flüssigen Phase die Oberflächenarbeit. Dann führt jede weitere Anlagerung von Atomen/Molekülen an den Keim zu einem Energiegewinn. Die Größe dieses kritischen Keimes wird durch die Übersättigung bzw. Unterkühlung des Gases bestimmt.

Beim Kondensationsvorgang von Metalldämpfen auf Substraten sind eine Reihe von teils konkurrierenden Prozessen beteiligt. Auf der Substratoberfläche eintreffende Metallatome oder -moleküle verlieren ihre kinetische Energie durch Anregung von Phononen im Substrat. Sie werden durch das Adsorptionspotential an der Substratoberfläche eingefangen. Bei den Polyolefinen, d.h. den vernetzten Paraffinen, sind diese Potentiale nur sehr schwach, die Van der Waals-Wechselwirkung beträgt etwa 0,1 bis 0,2 ev. Die eingefangenen Atome/Moleküle diffundieren andererseits auch über die Substratoberfläche. Sie können die Oberfläche teilweise wieder verlassen, wenn sie durch Phononenstöße genügend angeregt werden, um das Adsorptionspotential des Substrates zu überwinden. Die Verweilzeit eines eingesfangenen Atomes hängt daher von der Tiefe des Adsorptionspotentials, der Frequenz der Gitterschwingungen und ihre Energieverteilung bei der Substrattemperatur ab. Eingefangene Einzelatome oder -moleküle, die über die Substratoberfläche diffundieren, stoßen mit anderen Atomen Molekülen bzw. mit größeren Aggregaten zusammen und gehen auf diese Weise der Einzelpopulation verloren. Die Formation von Aggregaten, d.h. Cluster aus mindestens zwei Einzelpopulationen, wird sowohl durch die Beweglichkeit der Einzelatome an der Oberfläche bestimmt, als auch durch die Häufigkeit und Größe der Stoßpartner. Unter der Annahme, daß nur Einzelatome an der Oberfläche beweglich sind, wird die Beweglichkeit durch die Diffusion der Einzelatome bestimmt. Die Anlagerung einzelner Atome an größere Keime wird dann durch geometrische Einfangzonen bestimmt, die von Form und Größe der Keime abhängen. Für Metalle mit Bindungsenergien von großer 1 eV sind zweiatomige Keime bei Substrattemperaturen von unterhalb 300°C bereits stabil, wobei über diese zweiatomigen Keime dann die Bildung größerer Keime erfolgt.

Bei dem erfindungsgemäßen Verfahren läßt sich nun die Herstellung selektiv bedampfter Strukturen dadurch erreichen, daß das aufgedampfte Metall, Halbmetall oder Halbleitermaterial unterschiedlich starke Wechselwirkungen zu den verschiedenen Substratmaterialien aufweist. Das bedeutet dann, daß bei ansonsten gleichen Bedingungen die Verweilzeit der eingefangenen Atome auf den verschiedenen Bereichen des Substrats, z.B. den Kohlenstoffoberflächen einerseits und den Oberflächen des vernetzten Paraffins andererseits, verschieden sind und damit sich das aufgedampfte Material auf den freien Kohlenstoffstrukturen nicht aber auf dem vernetzten Paraffin abscheidet.

Mit dem erfindungsgemäßen Verfahren lassen sich somit in einfacher Weise Mikrostrukturen, wie z.B. Leiterbahnen, minimalisierte Sensoren und Membrane ohne Masken und ohne Entwicklungsprozesse herstellen. Das erfindungsgemäße Verfahren hat im Vergleich zu den bisher bekannten Verfahren den weiteren Vorteil, daß das Aufbringen der strukturierbaren Schicht, die Strukturierung der Schicht mittels Bestrahlen im Rastermodus, das Entfernen des durch die elektromagnetische Strahlung nicht veränderten Teils und schließlich das Aufbringen der Metallschicht durch Kondensation eines Metalldampfes in direkt aufeinanderfolgenden Schritten in einer Vakuumkammer ausgeführt werden kann.

Die Erfindung sei anhand eines Beispiels näher erläutert.

Beispiel

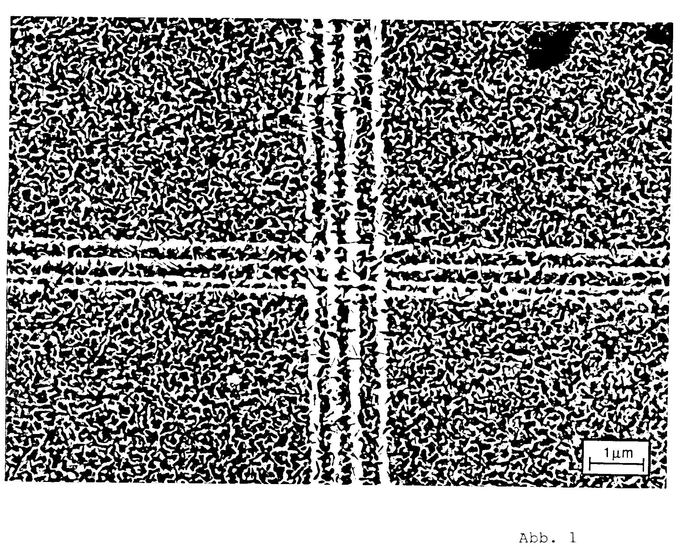

Ein dünner Film aus Paraffin wurde auf heißer Phosphorsäure gegossen und anschließend in Rastermodus eines Phillips 400T - Transmissionselektronenmikroskop belichtet. Der Spotdurchmesser beträgt 20 nm, die Linienzeit beträgt 1 msec, jede Linie wurde 60 sec belichtet. (= 60000 Durchläufe). Bei einem Emissionstrom von 11 μA kann die Strahlendosis ohne Berücksichtigung von Verlusten durch Blenden auf maximal 100 nC/cm$^2$ abgeschätzt werden. Anschließend wurde das nicht vernetzte Paraffin bei 120°C und Drücken besser als 5 x 10$^{-6}$ mbar 5h abgedampft. Die folgende Bedampfung mit Tellur wurde bei einer Substrattemperatur von 150°C und mit einer Rate von kleiner als 0,02 nm/sec ausgeführt. Zu Beginn des Aufdampfens war der Druck besser als 5 x 10$^{-6}$ mbar und stieg im Verlauf des Aufdampfprozesses auf 1 x 10$^{-5}$ mbar an. Einen Ausschnitt aus der bedampften Oberfläche zeigt die Abbildung.

**Patentansprüche**

1. Verfahren zum selektiven Aufbringen von Metallen, Halbmetallen oder Halbleitermaterialien auf mikrostrukturierte Substrate, dadurch gekennzeichnet, daß die Mikrostrukturierung durch Veränderung der Oberflächentopographie oder Molekularstruktur der Substrate mittels elektromagnetischer Strahlen erzeugt wird und anschließend auf den so veränderten Substraten das Aufbringen der Metalle, Halbmetalle oder Halbleitermaterialien durch selektive Kondensation erfolgt.

2. Verfahren gemäß Anspruch 1, dadurch gekennzeichnet, daß die Substrate zumindest auf der Oberfläche organische Moleküle oder Polymere aufweisen, welche sich durch die Wechselwirkung mit elektromagnetischen Strahlen zur Strukturierung lokal verändern lassen.

3. Verfahren gemäß Anspruch 1, dadurch gekennzeichnet, daß auf die amorphe Kohlenstoffschicht eines Substrats im Vakuum ein Paraffinfilm aufgedampft, der Paraffinfilm mittels Bestrahlen mit Elektronenstrahlen im Rastermodus unter Vernetzung strukturiert, die nichtvernetzten Bereiche des Paraffinfilms durch Abdampfen im Vakuum entfernt und eine Metallschicht durch Kondensation des Metalldampfes auf die freien Rasterflächen der Kohlenstoffschicht des Substrats aufgebracht wird.

Abb. 1